# EUROPEAN PATENT APPLICATION

(11) **EP 0 843 359 A2**
(43) Date of publication of application: **20.05.1998**
(21) Application number: 97309104.4
(22) Date of filing: 12.11.1997
(51) Int. Cl.: H01L 27/108, H01L 21/8242, H01L 21/321

(54) **Method for chemical mechanical polishing a semiconductor device using slurry**

(30) Priority: 14.11.1996 US 30879 P
(71) Applicant: TEXAS INSTRUMENTS INC., Dallas, Texas 75243 (US)
(72) Inventor: Niuya, Takayuki, Plano, Texas 75025 (US)
(74) Representative: Harris, Ian Richard

(57) **Abstract**

A method for fabricating a memory integrated circuit having a storage capacitor, the method including the step of forming a transistor having a contact region 453 at a surface of a semiconductor substrate. The transistor, excluding the contact region is then covered with a first material 462, 466. The contact region and first material are covered with a layer of a second material 470, which is then planarized using a technique such as chemical-mechanical polishing. Portions of the layer of second material are removed to form a cavity having a bottom made of the first material and sides made of the second material. The cavity also exposes the contact region. A first conductive layer of polysilicon 472 for example is then formed in the cavity to conform to the bottom and sides. The first conductive layer also extends over the surface of the first layer 470. This portion of the first conductive layer may then be selectively removed from the portion of the layer 472 in the cavity by chemical-mechanical polishing, given the planar nature of the underlying layer 470. The process continues with the formation of a dielectric layer over the first conductive layer in the cavity and with the formation of a second conductive layer, the field plate, over the dielectric layer.

## Description

### FIELD OF THE INVENTION

This invention relates generally to integrated circuits, and more specifically to dynamic random access memory integrated circuits.

### BACKGROUND OF THE INVENTION

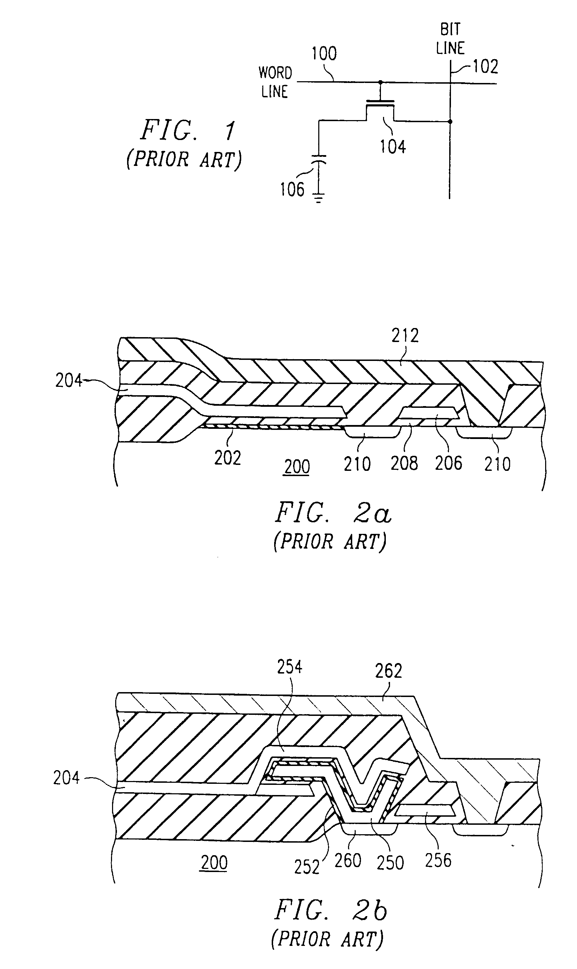

A dynamic random access memory integrated circuit (DRAM) provides temporary storage of digital information. A distinctive feature of the DRAM is that the information stored in the circuit is quickly lost unless it is refreshed. The reason that information storage is only temporary in a DRAM is that the data storage is in the form of a charged capacitor. The cell shown in Figure 1 is the heart of the memory circuit. It includes a word line 100 and bit line 102 connected to a pass transistor 104 and a capacitor 106. When the voltage on the word line 100 is raised, the pass transistor 104 turns "ON" and the bit line 102 is connected to the storage capacitor 106. The information stored in the cell corresponds to whether the storage capacitor is charged or discharged. Unfortunately, capacitors leak charge and if not refreshed, the cell containing information corresponding to a charged capacitor would soon contain information corresponding to a discharged capacitor.

A natural solution to the problem of charge leakage is simply to increase the size of the capacitor. This approach, however, runs counter to the constant need for a smaller cell size, since in many DRAM circuits the storage capacitors alone can occupy as much as fifty to sixty percent of the die area of the circuit. The high premium placed on die area has resulted in cell designs in which the storage capacitor is formed not on the substrate surface, but instead on a protrusion that extends above the substrate surface. Such vertically-formed capacitors are known in the industry as a "stacked cell." The use of a stacked cell allows for a higher storage capacitance without occupying precious semiconductor die area.

Figure 2a shows a prior art planar DRAM cell and Figure 2b shows a prior art stacked cell. In Figure 2a the "storage node," or the terminal of the capacitor connected to the transistor lies in the semiconductor substrate 200 beneath the capacitor dielectric 202. The other terminal, or field plate, of the planar capacitor is typically polysilicon and is shown as element 204. The wordline 206 comprises the gate interconnection for the pass transistor and lies over the gate dielectric 208 and between the source and drain implantation regions 210. The bitline 212 runs perpendicularly to and over the wordline and storage capacitor. In the stacked cell shown in Figure 2b, both plates of the capacitor are polysilicon. The storage node 250 is convoluted and only contacts the substrate at transistor contact region 260. The wordline 256 and bitline 262 are in essentially the same position as in the structure of Figure 2a. The capacitor dielectric 252 is typically oxide or a combination of oxide and nitride. The field plate 254 conforms to the convolutions of the storage node 250 to create a capacitor with a larger surface area than with the capacitor of Figure 2a. The drastically reduced die area occupied by the stacked cell of Figure 2b is also apparent in a comparison with the structure of Figure 2a.

Designers of future generations of DRAMs demand that the storage capacitor occupy even less die area than that of the structure shown in Figure 2b. One problem with conventional processes for forming stacked cell capacitors is that the vertical nature of the capacitor requires relatively thick layers (typically oxide) for the capacitor's formation. Contact from the capacitor to the contact region (source or drain) of the pass transistor is complicated by the thick layers since the area of contact is often less than 0.5 µm in dimension, and will continue to be made smaller in future DRAM generations. Forming such a small opening in thick layers is very difficult and is a source of process complexity. For example, conventional processes rely on polysilicon or silicon nitride hardmasks with openings of about 0.36 µm to gain the selectivity necessary for etching such small holes in thick layers of oxide. Even using such a hardmask, the etch depth that can be achieved is often only about 1.0 µm when a depth of approximately 50% or greater is desired. To achieve the needed depth, prior processes typically rely on multiple masking steps where the bottom portion of the capacitor contact to the transistor is formed before the thick oxide layers are applied. The hole is then plugged with polysilicon and the thick layers necessary for forming the upper portions of the capacitor follow. The multiple mask steps necessary to form the capacitor in prior processes are thus complicated and economically unattractive. The present invention provides a simpler approach to the formation of stacked capacitors.

### SUMMARY OF THE INVENTION

Particular and preferred aspects of the invention are set out in the accompanying independent and dependent claims. Features of the dependent claims may be combined with those of the independent claims as appropriate and in combinations other than those explicitly set out in the claims.

In accordance with the principles of the present invention, there is disclosed herein a process for fabricating a capacitor of the type commonly used as a storage cell in a dynamic random access memory integrated circuit. The process takes advantage of both the surface planarity provided by a chemical-mechanical etching technique as well as the ability of such a technique to selectively remove thin layers from underlying dissimilar layers. In particular there is disclosed a process including the step of forming a contact region at a surface of a substrate, followed by the step of forming a first layer over the surface and the contact region. The surface of the first layer is then planarized, using chemical-mechanical polishing for example. Portions of the first layer are then removed to form a cavity or recess in the first layer in which the capacitor is to be formed. A lower electrode layer, of polysilicon for example, is then deposited over the surface of the first layer and conformally in the cavity. Chemical-mechanical polishing is then used to remove the portions of the lower electrode layer from the surface of the first layer, while leaving the lower electrode layer in the cavity. A dielectric layer is then formed over the portion of the lower electrode layer remaining in the cavity, followed by an upper electrode layer of polysilicon for example.

Further in accordance with the principles of the invention, there is disclosed a method for fabricating a memory integrated circuit including the step of forming a transistor having a contact region at a surface of a semiconductor substrate. The transistor, excluding the contact region, is then covered with a first material. The contact region and first material are covered with a layer of a second material, which is then planarized using a technique such as chemical-mechanical polishing. Portions of the layer of second material are removed to form a cavity including a bottom formed of the first material and sides formed of the second material. In addition, the contact region is exposed in the cavity. A first conductive layer of polysilicon for example is then formed in the cavity to conform to the bottom and sides. The first conductive layer also extends over the surface of the layer of second material. This portion may then be selectively removed and separated from the portion of the layer in the cavity by chemical-mechanical polishing, given the planar nature of the underlying layer. The process continues with the formation of a dielectric layer over the first conductive layer in the cavity and with the formation of a second conductive layer, the field plate, over the dielectric layer.

Planarization of the layer in which the crown or stacked portion of a memory storage cell is formed simplifies the process by allowing the use of chemical-mechanical polishing to remove subsequently-applied layers. The process is a simple alternative to the use of spin-on glass or hydrogen silsesquioxane along with an etch-back step to form the crown or stacked portion of the capacitor.

### BRIEF DESCRIPTION OF THE DRAWINGS

Exemplary embodiments of the invention are described hereinafter, by way of example only, with reference to the accompanying drawings, in which:
Figure 1 is a schematic diagram of a prior art memory cell;
Figure 2a is a cross-sectional diagram of a prior art memory cell having a planar capacitor;
Figure 2b is a cross-sectional diagram of a prior art memory cell having a stacked cell capacitor;
Figures 3a to 3bb are cross-sectional diagrams of steps in a first preferred embodiment process of the instant invention; and
Figures 4a to 4e are cross-sectional diagrams of steps in a second preferred embodiment process of the instant invention.

### DETAILED DESCRIPTION OF PREFERRED EMBODIMENTS

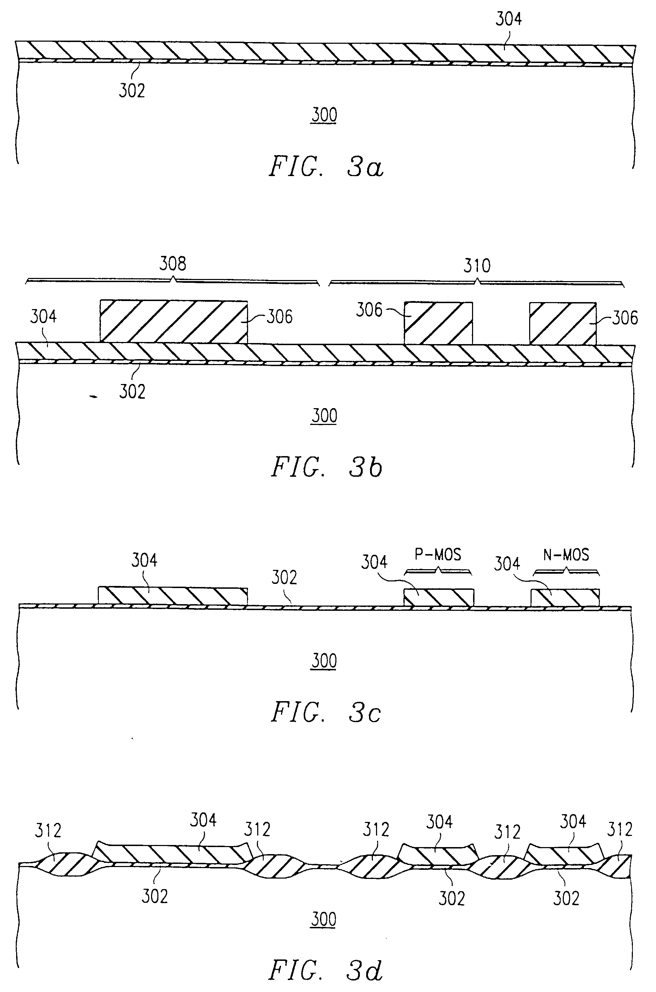

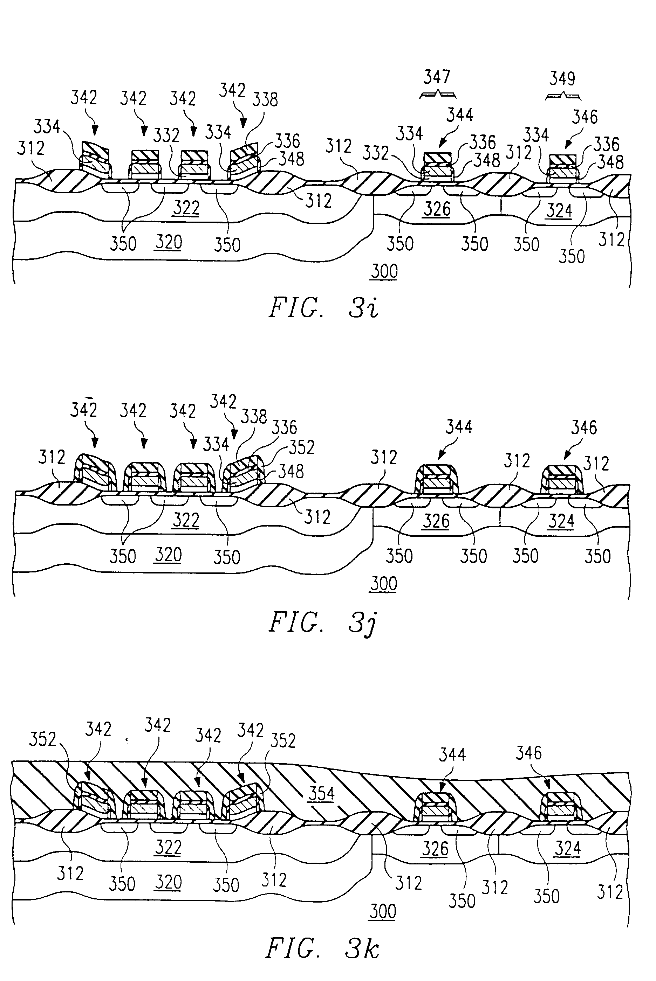

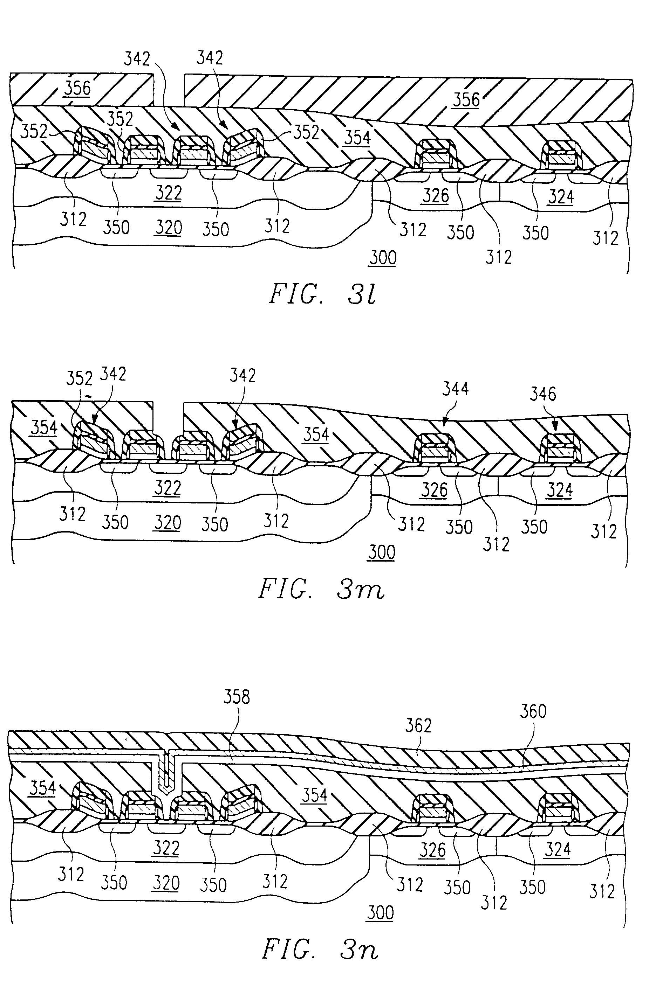

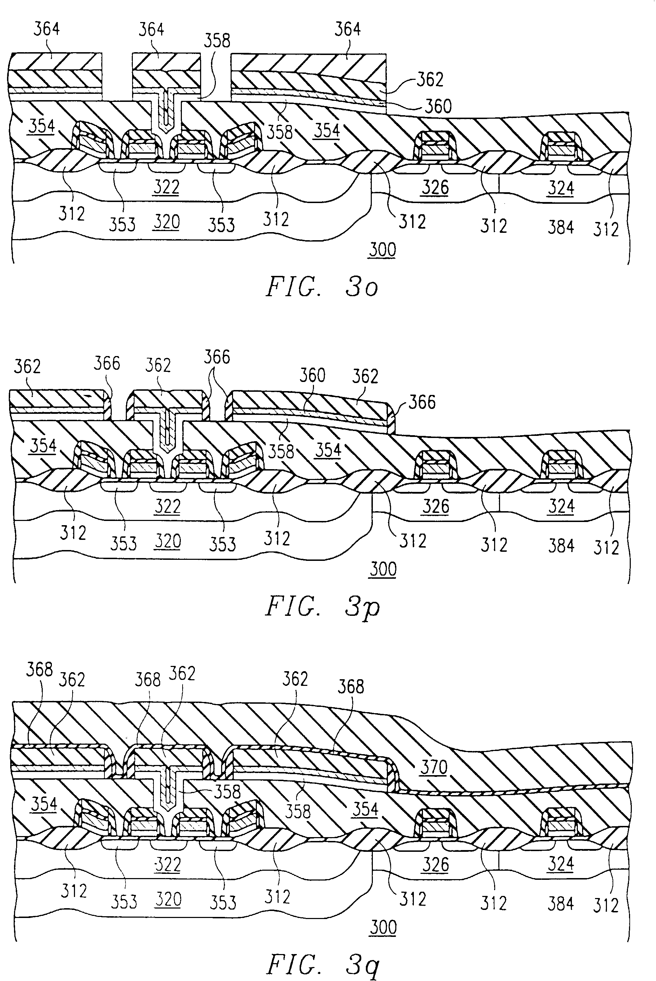

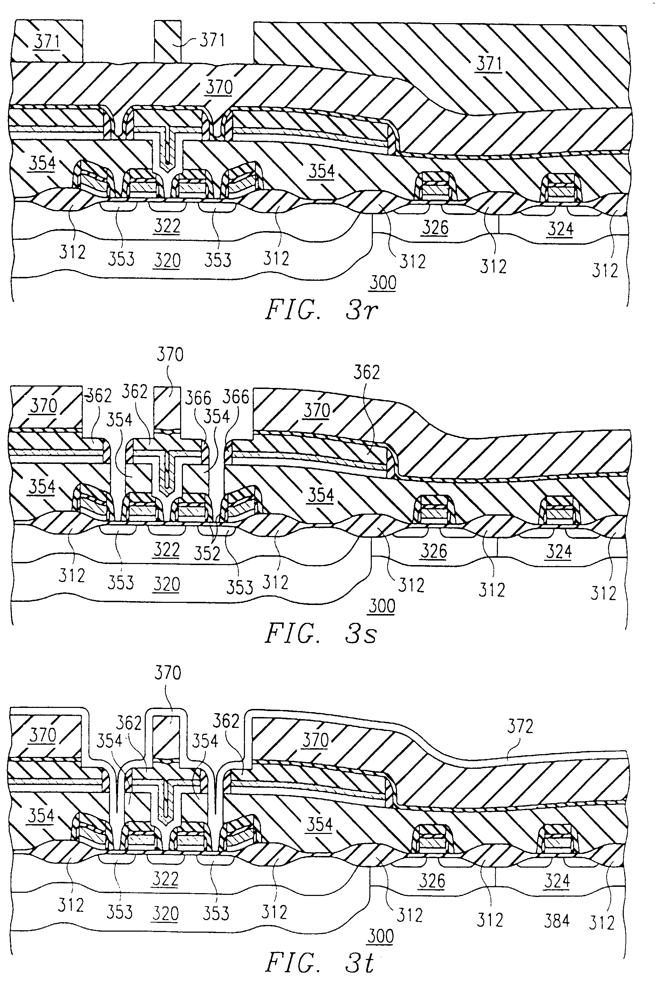

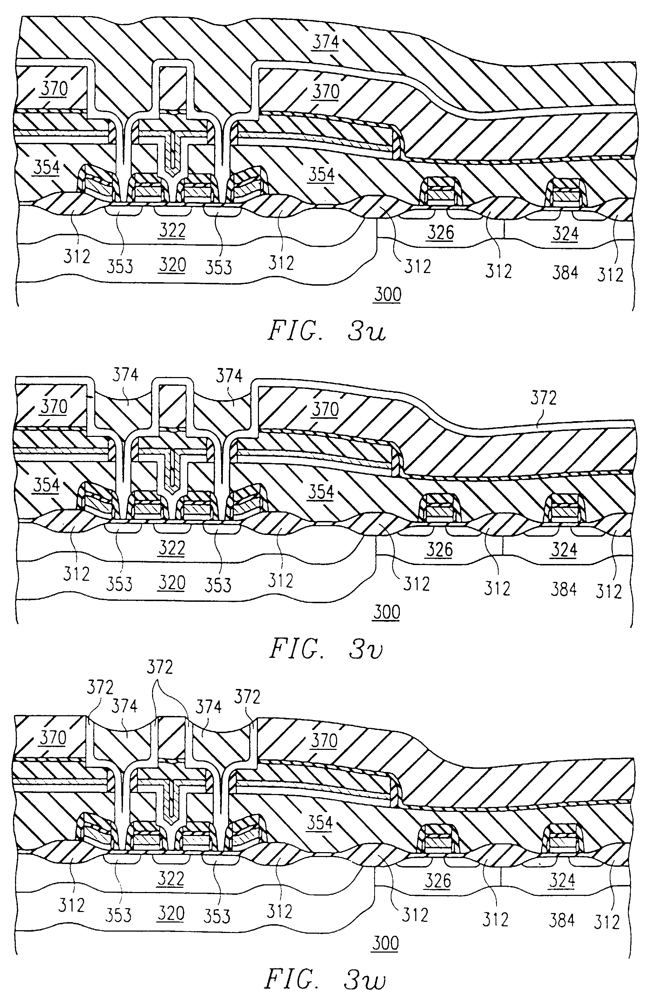

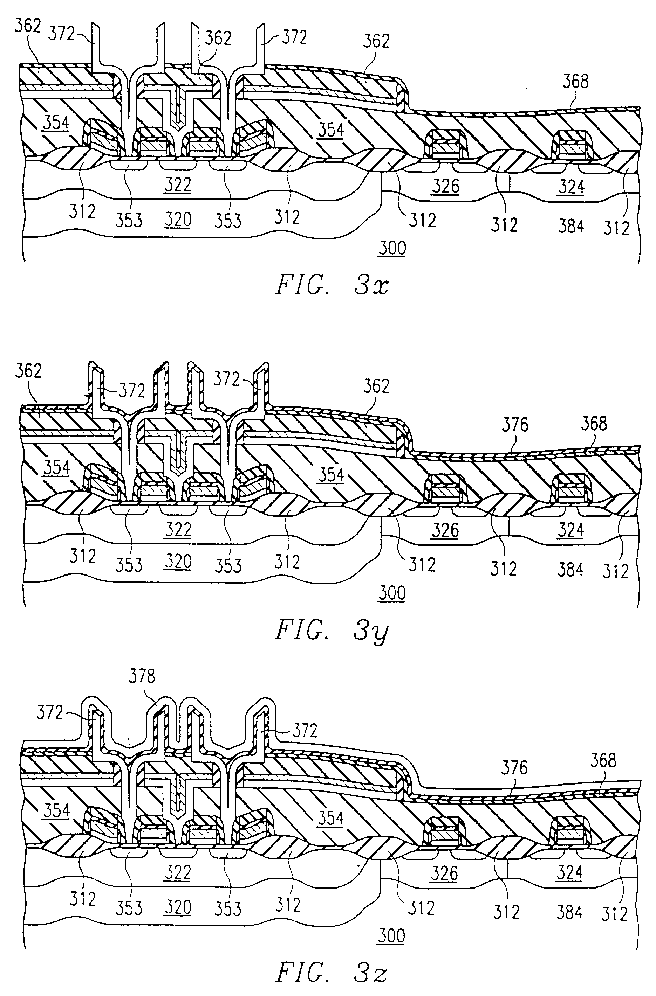

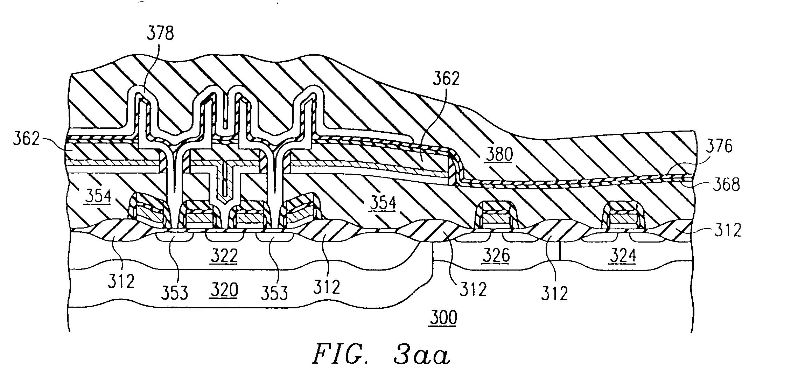

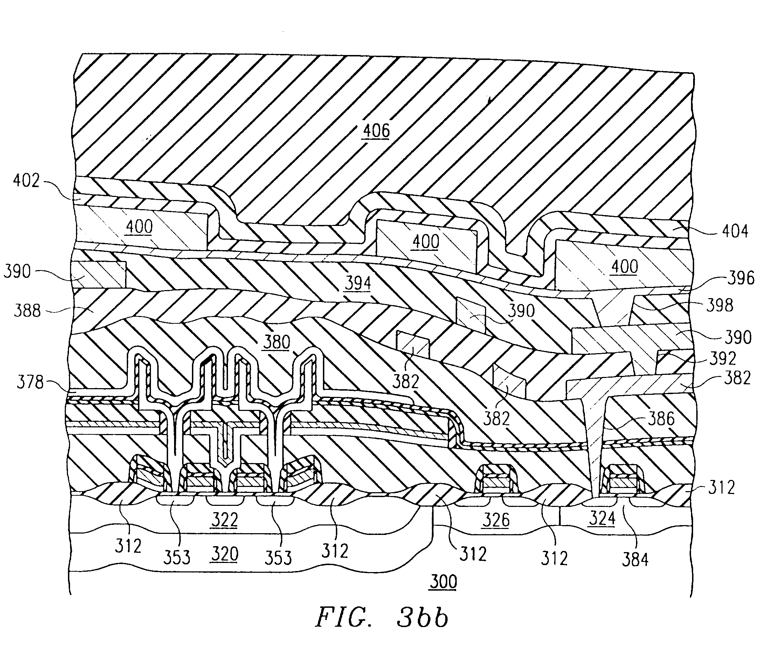

A first preferred embodiment of the invention is shown in Figures 3a-3bb. In Figure 3a a layer 302 of silicon dioxide (SiO₂) approximately 13.5 nm in thickness is formed over a silicon substrate 300 having p-type background doping. A layer 304 of silicon nitride (Si₃N₄) approximately 140 nm in thickness is then formed over the oxide layer 302. In Figure 3b photoresist and an anti-reflective coating, shown collectively as layer 306 are deposited and patterned over the nitride layer 304, Figures 3b through 3aa are cross-sectional diagrams of a DRAM circuit in which the memory cell is formed in the left portion of the diagram, indicated generally by brackets and element 308. The right portions of the diagrams, indicated generally in Figure 3b by brackets and element 310, show the structure of the n-mos and p-mos transistors that make up the peripheral circuitry of the integrated circuit.

Following the patterning of the photoresist 306, the nitride layer 304 is dry-etched from areas not covered by resist layer 306, as shown in Figure 3c. In Figure 3d, field oxide regions 312 are formed by heating the structure preferably in steam at approximately 1050 °C for about 40 minutes. Field oxide regions 312 are approximately 400 nm in thickness. It may be appreciated that forms of isolation other than the local oxidation of silicon may be employed. An example of such an alternative technique is trench isolation.

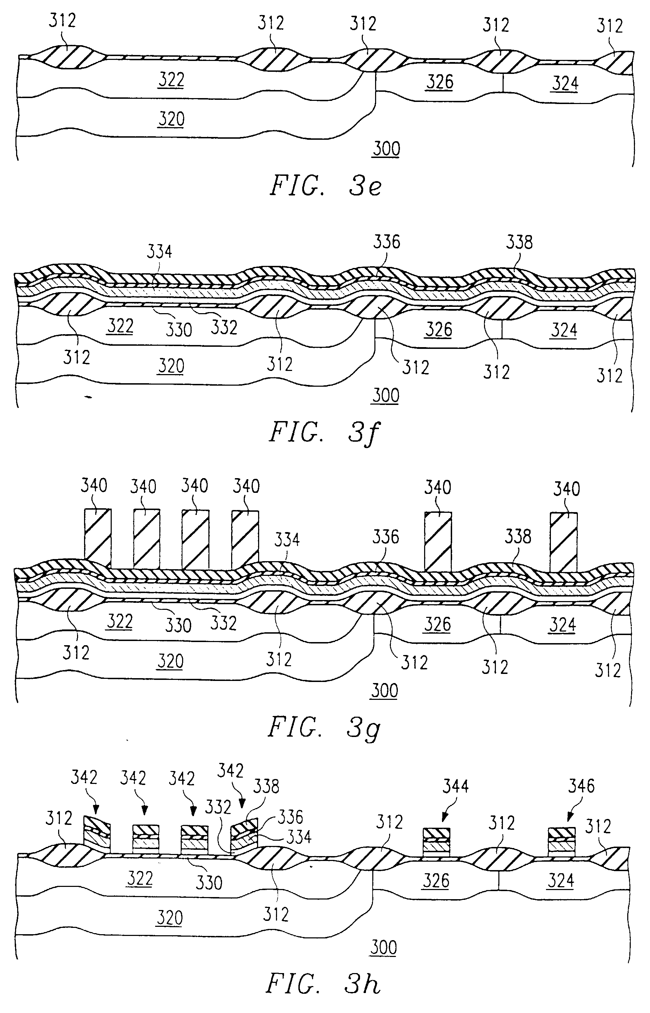

The structure is now ready for a series of implantation steps that yield the structure of Figure 3e. Initially, the deep well 320 is formed by the implantation of phosphorus for example at a dose of approximately 6x10¹² cm⁻³ and an energy of about 500 keV. The implantation of the p-well 322 over which is formed the memory cell, and the p-well 324 over which the n-mos periphery transistors are formed, comprises a three step boron implantation procedure. The first dose of boron is approximately 8.0x10¹² cm⁻³ at an energy of about 300 keV; the second is approximately 9.0x10¹² cm⁻³ at about 180 kev; and the third is approximately 2.0x10¹² cm⁻³ at about 20 keV. The n-well 326 over which the p-mos periphery transistors are formed comprises a two step implantation of phosphorus for example; the first dose of approximately 2.0x10¹³ cm⁻³ at about 500 keV and the second dose of approximately 5.0x10¹² cm⁻³ at about 250 keV.

In Figure 3f the structure is cleaned following the implantation steps and gate oxide 330 is formed at 850 °C preferably in steam. The thickness of the gate oxide is approximately 9 nm. The gate interconnect comprises a polysilicon layer 332 capped by a tungsten silicide (WSi₂) layer 334. The polysilicon layer 332 is approximately 62 nm in thickness, while the WSi2 layer 334 is about 120 nm. These layers are then capped by an oxide layer 336 of approximately 10 nm thickness formed through decomposition of tetraethylorthosilicate (TEOS) for example, and a nitride layer 338 of about 200 nm thickness.

In Figure 3g, photoresist and an anti-reflection layer (shown compositely as element 340) are deposited and patterned to cover the desired location of the transistor gates. The layers 332, 334, 336, and 338 not covered by photoresist 340 are then removed to leave the structure of Figure 3h. Gate structures 342 comprise the wordlines of the memory cell, while structures 344 and 346 comprise the gates of exemplary peripheral p-mos and n-mos transistors, respectively. It may be appreciated that the number of gates or wordlines depicted in Figure 3g and the figures that follow are chosen to facilitate a clear representation of the storage cell capacitors. One skilled in the art will appreciate that the memory array consists of many more similarly arranged wordlines, transistors, and storage cell capacitors than is shown here.

In Figure 3i the polysilicon 332 and WSi₂ 334 layers are oxidized to produce an approximately 9.5 nm thick sidewall oxide 348. This step is followed by the masking of the p-mos transistor 347 and implantation of an initial n-type lightly doped drain (LDD) region 350 over both sides of the memory cell gates 342 and the n-mos gate 346. The memory cell is then masked and a second LDD implant is made for the n-mos transistor 349. Similarly, the memory cell transistors and the n-mos transistor 349 are then masked for the implantation of p-type dopants to form the LDD pattern 350 on either side of gate 344.

In Figure 3j a nitride layer 352 is formed over the entire structure to a thickness of approximately 100 nm. The nitride layer 352 is then anisotropically etched to remove the layer from all portions of the structure except the sidewalls of the gate structures. The n-mos and p-mos transistors are then alternately exposed to allow for the implantation of high concentrations of arsenic and boron, for example, which form highly doped source and drain contacts (not separately shown) within the regions 350 previously subjected to the LDD implants.

Following the implantation of source/drain dopants, oxide layer 354 is formed over the structure by first decomposing TEOS to produce an approximately 50 nm oxide layer and then by depositing a layer of borophosphosilicate glass (BPSG) in a thickness of approximately 500 nm. The oxide layer is then etched back to a thickness of approximately 120 nm as shown in Figure 3k.

In Figure 31 photoresist 356 is deposited and patterned to expose the region in which the bitline contact to the memory cell transistors is to be made. The exposed portion of oxide layer 354 is then removed in an anisotropic reactive ion etching process preferably using carbon monoxide (CO) as the primary etchant and at a pressure of approximately 100 mTorr and an RF power of 1500 Watts. The CO etch does not appreciably remove the nitride 352 that coats the sidewalls of gate structures 342. The etching of the oxide and removal of the masking photoresist yields the structure shown in Figure 3m.

In Figure 3n the bitline contact to the source/drain implantation region 350 is established by depositing first a polysilicon layer 358 approximately 62.0 nm in thickness to cover the surface of oxide 354 and the depression left by the etching discussed with reference to Figures 31 and 3m. Polysilicon layer 358 is doped in situ during its deposition with phosphorus for example to a concentration of approximately 1.65x10²⁰ cm⁻³. Polysilicon layer 358 is covered with WSi₂ layer 360 of about 120.0 nm thickness to lower the overall resistivity of the bitline interconnect. WSi₂ layer 360 is then covered with an approximately 200.0 nm nitride layer 362.

In Figure 3o the nitride layer 362, WSi₂ layer 360, and polysilicon layer 358 are covered with photoresist 364, which is patterned to expose the location of the storage cell capacitor contacts to the source/drain contacts 353 of the memory cell transistors. The nitride layer 362, WSi₂ layer 360, and polysilicon layer 358 are removed in an anisotropic etching process. The nitride layer 362 is removed using a reactive ion etching apparatus with SF₆ for example being the primary etchant, while the WSi₂ and polysilicon layers are removed using a chlorine etch for example.

Referring now to Figure 3p, sidewall nitride 366 is formed by depositing an approximately 100 nm thick layer of silicon nitride over the surface of the structure. The nitride is then anisotropically etched using SF6 for example as the primary etchant to remove the nitride layer from the surface of oxide layer 354 and the surface of nitride layer 362 to leave only nitride sidewalls 366.

In Figure 3q an etch stop nitride layer 368 having a thickness of approximately 25 nm is deposited over the surface of the structure. A crown oxide layer 370 is then deposited by decomposition of TEOS over the nitride etch stop layer to a thickness of approximately 500 nm. In Figure 3r photoresist layer 371 is deposited and patterned to expose the portions of the crown oxide layer 370 over the desired location of the storage cell capacitors. Referring now to Figure 3s, the exposed portions of crown oxide layer 370 are removed using an anisotropic etching process with carbon monoxide for example as the primary etchant. The removal of the crown oxide layer 370 and oxide layer 354 is performed with relatively little removal of the vertical portion of nitride sidewalls 352 and 366 because of the anisotropic nature of the reactive ion etching process and the selectivity of the carbon monoxide etchant in removing oxide versus nitride layers. The horizontal surfaces of nitride layer 362 and sidewalls 366 and 352, however, are generally perpendicular to the direction of etching, and therefore a relatively greater portion of those nitride regions is removed during the etch, as is shown in Figure 3s. The resulting structure includes a cavity with a lower portion defined by sidewall nitride 352, oxide layer 354, and nitride sidewalls 366.

The patterned opening of photoresist layer 371 in the step shown in Figure 3r is much wider than the lower portion of the cavity formed in Figure 3s. The opening in the photoresist 371 in Figure 3r is sufficiently wide (typically between 0.7 and 1.0µm) that removal of both the crown oxide layer 370 and the oxide layer 354 may be accomplished in a single etch step. The nitride sidewalls 366 and 352 ensure that the etch is confined in the lower portion of the cavity to the relatively narrow width consistent with exposing contact region 353 (typically about 0.36 µm), while photoresist 371 defines the dimension of the upper region of the cavity formed essentially by the removal of portions of crown oxide layer 370. It is preferable that the upper portion of the cavity, that is, the portion having sides of the crown oxide layer 370 and a bottom of the nitride regions 362 and 366, be at least about twice as wide as the lower portion, whose width is determined by the nitride sidewalls 366 and 352. The cavity resulting from the single etch step described above possesses a relatively large surface area in which the crown or stacked cell capacitor may be formed.

The removal of oxide layer 354 exposes the source/drain contacts 353 of the memory cell transistors. Electrical contact with the transistor is then established in Figure 3t by depositing a polysilicon layer 372 that serves as the bottom electrode of the storage cell capacitor. The polysilicon of layer 372 is approximately 62 nm thick and is doped with phosphorus for example to a concentration of approximately 1.65x10²⁰ cm⁻³. In Figure 3u glass layer 374 is then spun on to cover polysilicon layer 372. Glass layer 374 is preferably hydrogen silsesquioxane (HSQ) spun to a thickness of approximately 400 nm. In Figure 3v glass layer 374 is etched back to expose polysilicon layer 372. Portions of glass layer 374 remain in depressions in the structure coinciding with the desired location of the storage cell capacitor. These remaining portions of layer 374 protect the polysilicon layer 372 when the exposed portions of that layer are removed preferably with a chlorine-based etch as shown in Figure 3w.

In Figure 3x crown oxide layer 370 and the remaining portions of the spin-on glass layer 374 are removed using a hydrofluoric acid solution, for example, leaving the vertical portions of layer 372 extending above the substrate as shown. Layer 372 forms each storage cell capacitor's bottom plate electrode.

The capacitor dielectric 376 preferably comprises an approximately 6 nm of silicon nitride deposited over the entire structure as shown in Figure 3y, followed by oxidation at approximately 850°C for about 18 minutes preferably in steam to reduce the defect density of the nitride film. It may be appreciated that other dielectrics may be suitable; examples include tantalum pentoxide, barium strontium titanate, lead zirconate titanate, and strontium bismuth titanate. In Figure 3z an approximately 85 nm thick layer of polysilicon 378 is deposited over the capacitor dielectric 376. Polysilicon layer 378 is doped in situ with phosphorus for example to a concentration of approximately 4.5x10²⁰ cm⁻³.

In Figure 3aa the polysilicon layer 378 is etched with a combination of chlorine and SF6 for example to define the extent of the field or common plate electrode of the storage cell capacitors. Oxide layer 380 is then formed over the structure by first decomposing TEOS to produce an approximately 100 nm oxide layer and then by the deposition of borophosphosilicate glass (BPSG) in a thickness of approximately 800 nm. The oxide layer is then etched back to a thickness of approximately 640 nm.

Figure 3bb shows the structure as it appears prior to the packaging of the circuit. Over the oxide layer 380 is deposited a first metal layer 382 with access to peripheral transistor 384 through via 386. First metal layer 382 is patterned with photoresist and etched as shown to connect portions of the integrated circuit as desired. Oxide layer 380 and first metal layer 382 are then covered by oxide layer 388. Second metal layer 390 is then deposited over oxide layer 388 with access to the first metal layer 382 through via 392. Second metal layer 390 is patterned with photoresist and etched as shown to connect portions of the integrated circuit as desired. Oxide layer 388 and second metal layer 390 are covered by oxide layer 394. Barrier metal layer 396 is then deposited over oxide layer 394, with access to second metal layer 390 through via 398. Third metal layer 400 is deposited over barrier metal layer 396, patterned with photoresist, and etched as shown to connect portions of the integrated circuit as desired. The barrier metal layer 396 and third metal layer 400 are then covered with oxide layer 402. Oxide layer 402 is covered with nitride layer 404, which is in turn covered with polyimide layer 406.

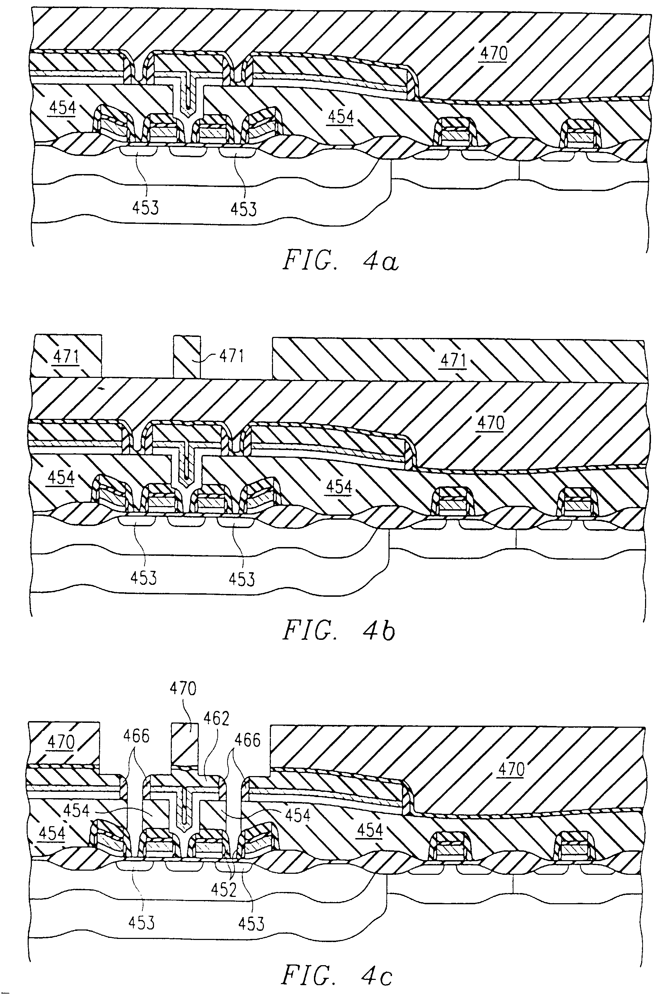

In a second preferred embodiment process the steps in the first preferred embodiment process that involve forming the crown portion of the storage capacitor cell are modified to simplify the process. Specifically, the steps illustrated in Figures 3q to 3w can be replaced with those illustrated in Figures 4a to 4e. A feature of the second preferred embodiment process is the use of chemical-mechanical polishing (CMP) to level the surface of the structure prior to the formation of the crown portion of the storage capacitor cell.

CMP can be used for planarizing dielectric as well as semiconductor regions. The process involves both chemical and mechanical abrasion. Chemical abrasion is accomplished using a slurry to chemically weaken the surface to be leveled. The polishing slurry is typically a mixture of either a basic or an acidic solution, which comprises the chemical component of the slurry, in combination with alumina or silica particles. Mechanical abrasion is accomplished using a polishing pad against which a wafer or layer surface is pressed. Both the polishing pad and the wafer are rotated to cause the removal of surface material. The removed material is then washed over the edges of the polishing pads and into a drain by adding additional slurry. CMP planarization produces a smooth, damage-free surface for -subsequent device processing. It requires less steps than a deposition/etchback planarization and has good removal selectivity and rate control.

CMP is employed in the second preferred embodiment process as shown in Figure 4a. In that figure, the surface of the crown oxide layer 470 has been planarized using CMP with a slurry comprising potassium hydroxide (KOH) as the chemical component.

In Figure 4b photoresist layer 471 is deposited and patterned to expose the portions of the crown oxide layer 470 over the desired location of the storage cell capacitors. Referring now to Figure 4c, the exposed portions of crown oxide layer 470 are removed using an anisotropic etching process with carbon monoxide as the primary etchant. The removal of the crown oxide layer 470 and oxide layer 454 is performed with relatively little removal of the nitride sidewalls 452, 466 and the nitride layer 462 formed over the bitline because of the anisotropic nature of the reactive ion etching process and the selectivity of the carbon monoxide etchant in removing oxide versus nitride layers. The removal of layers 470 and 454 exposes the transistor contact region 453.

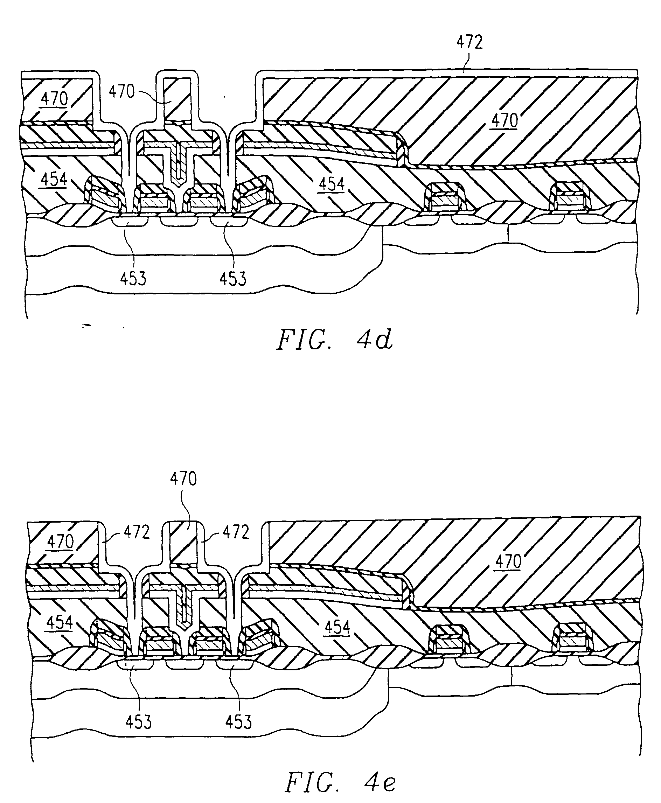

In Figure 4d, as in Figure 3t, polysilicon layer 472 is conformally deposited over oxide layer 470. In contrast to the spin-on glass and etch-back steps shown in Figures 3u and 3v, the planarized oxide layer 470 in Figure 4d results in a planar polysilicon layer 472. Thus, the portions of layer 472 not needed to define the storage node electrode of the capacitor are easily removed with another CMP step employing a slurry comprising KOH as the chemical agent. The removal of portions of layer 472 by CMP yields the structure shown in Figure 4e. The remaining steps of the process are identical to those shown in Figures 3x through 3bb with reference to the first preferred embodiment process.

Planarization of oxide layer 470 with CMP is an alternative to application of a spin-on glass (HSQ for example) with an associated etch-back step to form the polysilicon crown of the storage cell capacitor. The act of planarizing oxide layer 470 prior to the deposition of the crown polysilicon 472 makes it possible to selectively remove those portions of polysilicon layer 472 (see Figure 4d) that are deposited on the planarized surface.

Though the cavity shown in Figure 3s is shown to have a narrow portion bottomed on a contact region 353 at the surface of a semiconductor substrate, the skilled artisan will appreciate that the cavity could be formed to bottom on a contact region that lies not at the surface of the substrate, but at the surface of a subsequently-applied layer or region. An example would be an upper-level polysilicon interconnection layer.

While this invention has been described with reference to illustrative embodiments, this description is not intended to be construed in a limiting sense. Various modifications and combinations of the illustrative embodiments, as well as other embodiments of the invention, will be apparent to persons skilled in the art upon reference to the description.

## Claims

1. A method for fabricating a capacitor, comprising the steps of:
forming a first layer over a substrate;
planarizing a surface of said first layer;
removing portions of said first layer to form a cavity in said first layer;
forming a lower electrode layer over said surface of said first layer and substantially in said cavity;
chemically-mechanically polishing said lower electrode layer to remove said lower electrode layer from said surface of said first layer;
forming a dielectric layer substantially over a remaining portion of said lower electrode layer in said cavity; and
forming an upper electrode layer over said dielectric layer.

2. The method of Claim 1, wherein said step of forming a first layer comprises depositing oxide.

3. The method of Claim 1 or Claim 2, wherein said step of planarizing a surface comprises chemical-mechanical polishing

4. The method of any of Claims 1 to 3, wherein said step of forming a lower electrode layer comprises depositing doped polysilicon.

5. The method of any of Claims 1 to 4, wherein said step of chemically-mechanically polishing comprises polishing with a slurry comprising potassium hydroxide.

6. The method of any of Claims 1 to 5, wherein said step of forming a dielectric layer comprises forming a layer of nitride before effecting oxidation of said nitride.

7. The method of any of Claims 1 to 6, wherein said step of forming an upper electrode layer comprises depositing doped polysilicon.

8. The method of any of Claims 1 to 7 further comprising:
forming a contact region at a surface of a substrate.

9. The method of Claim 8, wherein said step of forming said first layer comprises forming said first layer over said surface and said contact region.

10. The method of Claim 8 or Claim 9, wherein said step of forming a lower electrode layer comprises forming said lower electrode layer over said surface of said first layer and in said cavity to contact said contact region.

11. A method for fabricating a memory circuit, comprising the steps of:
forming a transistor having a contact region at a surface of a semiconductor substrate;
covering said transistor, excluding said contact region, with a first material;
covering said first material and said contact region with a layer of a second material;
planarizing said layer of second material;
removing portions of said layer of second material to expose said contact region such that said removal of said portions of said layer of second material forms a cavity having a lower region of said first material and side regions of said second material;
forming a first conductive layer in said cavity to contact said contact region and conform to said lower region and side regions said first conductive layer also being formed on said planarized surface of said layer of second material;
chemically-mechanically polishing said first conductive layer to remove said layer from said planarized surface of said layer of second material;
forming a dielectric layer over said first conductive layer; and
forming a second conductive layer over said dielectric layer.

12. The method of Claim 11, wherein said step of covering said transistor with a first material comprises depositing a nitride layer over a bitline and nitride sidewalls on said bitline.

13. The method of Claim 11 or Claim 12, wherein said step of covering said first material and said contact region with a layer of second material comprises depositing an oxide layer.

14. The method of any of Claims 11 to 13, wherein said step of planarizing said layer of second material comprises chemical-mechanical polishing.

15. The method of any of Claims 11 to 14, wherein said step of chemically-mechanically polishing comprises polishing with a slurry comprising potassium hydroxide.

16. The method of any of Claims 11 to 15, wherein said step of forming a conductive layer in said cavity comprises depositing doped polysilicon.
